# EUROPEAN PATENT APPLICATION

(11) **EP 2 157 607 A1**
(43) Date of publication of application: **24.02.2010**
(21) Application number: 08777066.5
(22) Date of filing: 30.05.2008
(51) Int. Cl.: H01L 23/36, H01L 23/12, H05K 1/02

(54) **LAMINATED HEAT DISSIPATING BASE BODY, AND HEAT DISSIPATING UNIT AND ELECTRONIC DEVICE USING THE LAMINATED HEAT DISSIPATING BASE BODY**

(30) Priority: 30.05.2007 JP 2007143956
(71) Applicant: Kyocera Corporation, Kyoto-shi Kyoto 612-8501 (JP)
(72) Inventor: ABE, Yuichi, Kirishima-shi Kagoshima 899-4396 (JP); NAKAMURA, Kiyotaka, Kirishima-shi Kagoshima 899-4396 (JP)
(74) Representative: Beetz & Partner
(86) International application number: PCT/JP2008/060068
(87) International publication number: WO 2008/149818

(57) **Abstract**

A laminated heat dissipating base body (1) includes first and second bases (21, 22) having insulation properties arranged one above the other to face each other; a heat dissipating member (42) sandwiched between the first and second bases (21, 22); and circuit members (41) disposed on a top surface of the first base (21) arranged above and a bottom surface of the second base (22) arranged below, respectively. A bonding member is interposed at least either between the first base (21) and the heat dissipating member (42) or between the second base (22) and the circuit member (41), and includes an active metal layer (31, 32) containing an active metal disposed on the first and/or second base (21, 22) side thereof, and a bonding layer (51, 52) containing a metal disposed at least either on the heat dissipating member (42) side thereof or on the circuit member (41) side thereof.

## Description

### Technical field

The present invention relates to a laminated heat dissipating base body for mounting of electronic components including a semiconductor element such as an IGBT (Insulated Gate Bipolar Transistor) element, a dye-sublimation thermal printer head element, a thermal ink-jet printer head element and the like, which serves to increase the efficiency of dissipation of heat from such an electronic component, and to a heat dissipating unit employing the laminated heat dissipating base body. The invention also relates to an electronic device constructed by mounting the electronic components on the laminated heat dissipating base body and the heat dissipating unit as well.

### Background art

In recent years, as a heat dissipating base body for use in an electronic device such as a semiconductor apparatus typified by a power module such as a power transistor module and a switching power-supply module, a heat dissipating base body has been coming into wider use that is constructed by bonding a copper plate acting as a circuit member onto one main surface of a ceramic base and bonding a copper plate acting as a heat dissipating member for allowing good heat dissipation onto the other main surface thereof..The copper plate is provided with a heat sink for further heat diffusion toward the side opposite from the ceramic base.

As a ceramic base used for forming such a heat dissipating base body, a silicon nitride base which is excellent in electrical insulation property and in heat conductivity has recently been in common use (refer to Patent Documents 1 to 3).

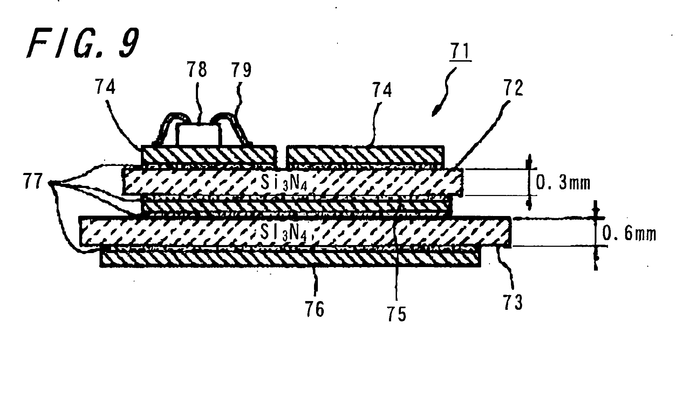

For example, in a laminated heat dissipating base body (multilayer silicon nitride circuit board) 71 as shown in Fig. 9, a rare earth element is contained in an amount of 1.0 to 17.5% by mass in terms of oxide, and impurity cationic elements; Li, Na, K, Fe, Ca, Mg, Sr, Ba, Mn, and B are contained in a total amount of less than or equal to 1.0% by mass (including 0% by mass as the limit of detection). Moreover, the laminated heat dissipating base body 71 is composed of a plurality of highly heat-conductive silicon nitride bases 72 and 73 having thermal conductivity of 60 W/(m·K) or above, and metal plates 74, 75, and 76 bonded to the highly heat-conductive silicon nitride bases 72 and 73 through layers 77 of a brazing material containing at least an active metal selected from among Ti, Zr, Hf, Nb, and the like (hereafter referred to as "active metal-containing brazing material).

In this construction, at a predetermined location on the circuit member (metal plate) 74 is mounted a semiconductor element 78 by means of solder bonding. The electrode portion of the semiconductor element 78 and that of the metal plate 74 are electrically connected to each other by a bonding wire 79.

As the technique of bonding the circuit member 74 and the heat dissipating member 76 to the corresponding highly heat-conductive silicon nitride bases 72 and 73, the active brazing method is adopted. As shown in Fig. 9, according to the active brazing method, the circuit member 74 and the heat dissipating member 76 in a state of having been heated to 780 to 900°C are bonded to the corresponding highly heat-conductive silicon nitride bases 72 and 73 through the active metal-containing brazing material layers 77 made of a Ag-Cu brazing material containing an active metal such as a Group 4 element, for example, Ti, Zr, and Hf.
Patent Document 1: Japanese Unexamined Patent Publication JP-A 10-93244 (1998)
Patent Document 2: Japanese Unexamined Patent Publication JP-A 2005-19875
Patent Document 3: Japanese Unexamined Patent Publication JP-A 2004-343035

### Disclosure of Invention

### Technical Problem

However, in the case of bonding the circuit member and the heat dissipating member to the highly heat-conductive silicon nitride bases by using the active brazing method, since the components are heated at high temperature, a thermal stress is developed during the bonding with the consequence that the laminated heat dissipating base body is prone to warpage in the course of cooling process.

Currently, in keeping with rapid advancement in high-integration design of semiconductor elements, reliability and durability high enough to withstand repeatedly-applied thermal stress have come to be increasingly demanded of a laminated heat dissipating base body mounting semiconductor elements.

The invention provides a durable and reliable laminated heat dissipating base body that allows suppression of warpage, and a heat dissipating unit and an electronic device using the laminated heat dissipating base body.

### Solution to Problem

A laminated heat dissipating base body of the invention comprises: first and second bases having insulation properties arranged one above the other to face each other; a heat dissipating member sandwiched between the first base and the second base; and circuit members disposed on a top surface of the first base arranged above the second base and a bottom surface of the second base arranged below the first base, respectively. A bonding member is interposed at least either between the first base and the heat dissipating member or between the second base and the circuit member. The bonding member includes an active metal layer containing an active metal disposed on the first and/or second base side thereof, and a bonding layer containing a metal disposed at least either on the heat dissipating member side thereof or on the circuit member side thereof.

Further, a heat dissipating unit of the invention comprises the laminated heat dissipating base body mentioned above; and a frame body which surrounds the laminated heat dissipating base body, and is so designed that a cooling medium is admitted into the frame body.

Furthermore, an electronic device of the invention comprises the laminated heat dissipating base body mentioned above; and an electronic component mounted on the circuit member of the laminated heat dissipating base body.

### Advantageous Effects of Invention

According to the laminated heat dissipating base body pursuant to the invention, the heat dissipating member and the circuit member are bonded through the bonding layer. In this case, in contrast to a case where the heat dissipating member and the circuit member are bonded through the active metal layer alone, it is possible to relax produced thermal stress, because the metal-made bonding layer is readily deformable in itself during cooling in the course of bonding operation.

Moreover, in the heat dissipating unit pursuant to the invention, the laminated heat dissipating base body can be cooled down efficiently and inexpensively without the necessity of providing a large-sized cooling device.

Further, the electronic device pursuant to the invention is free from accumulation of heat in the electronic components and hence succeeds in offering high heat dissipation capability.

### Brief Description of Drawings

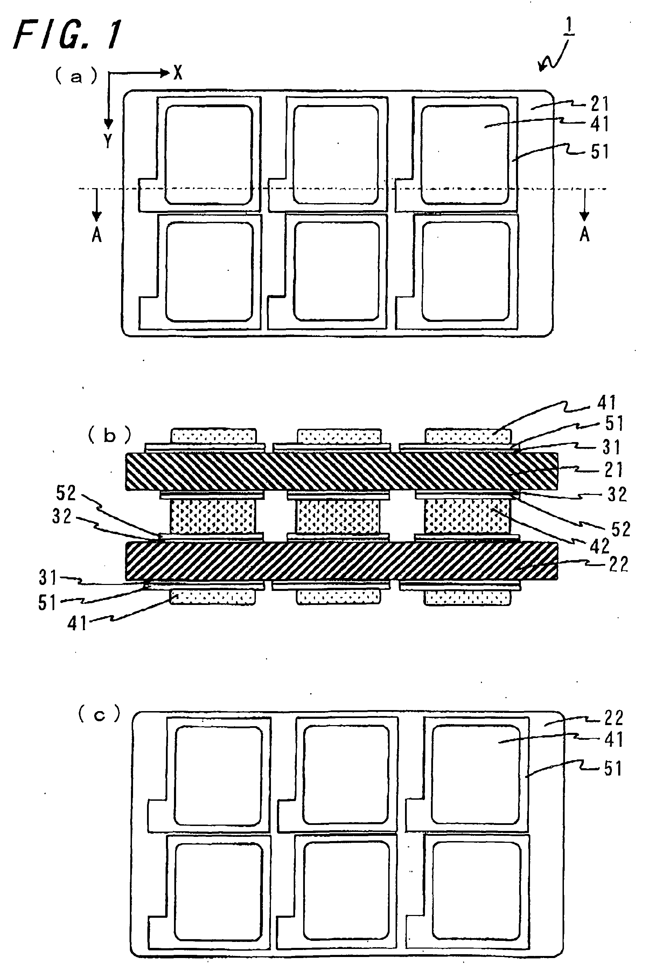

Fig. 1 is a diagram for explaining one embodiment of a laminated heat dissipating base body of the invention, wherein Fig. 1(a) is a plan view showing a circuit member disposed on a top surface of a first base arranged above in a planar view, Fig. 1(b) is a sectional view taken along the line A-A of Fig. 1(a), and Fig. 1(c) is a bottom view showing a circuit member disposed on the bottom surface of a second base arranged below in a planar view.

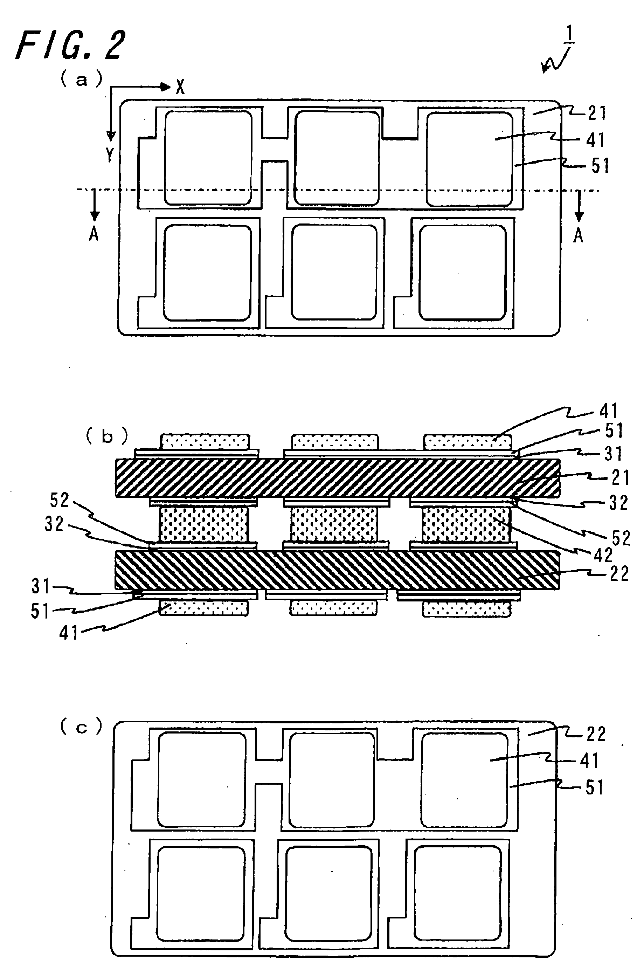

Fig. 2 is a diagram for explaining another embodiment of the laminated heat dissipating base body of the invention, wherein. Fig. 2(a) is a plan view showing the circuit member disposed on the top surface of the first base arranged above in a planar view, Fig. 2(b) is a sectional view taken along the line A-A of Fig. 2(a), and Fig. 2(c) is a bottom view showing the circuit member disposed on the bottom surface of the second base arranged below in a planar view.

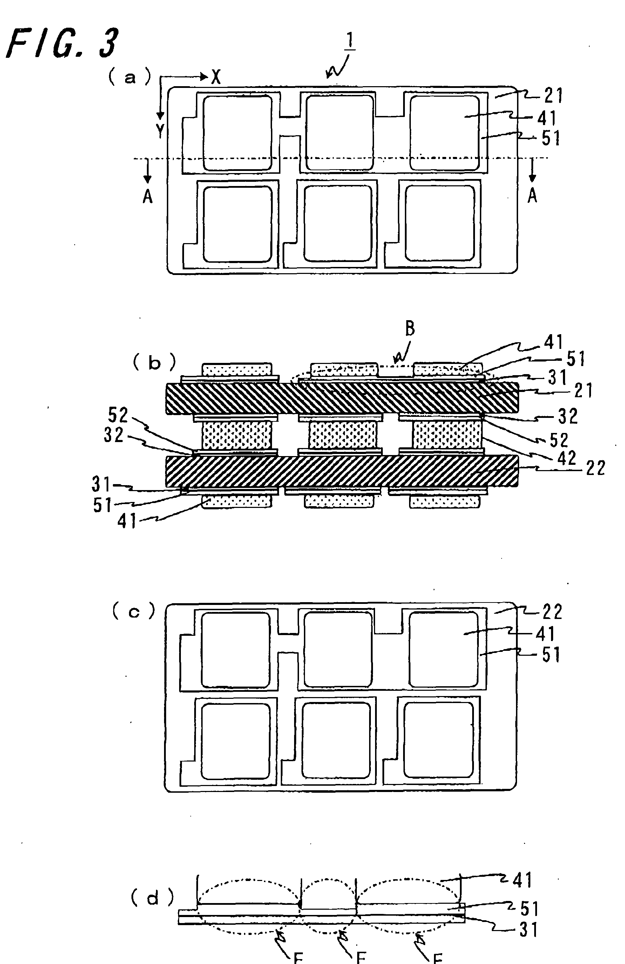

Fig. 3 is a diagram for explaining still another embodiment of the laminated heat dissipating base body of the invention, wherein Fig. 3(a) is a plan view showing the circuit member disposed on the top surface of the first base arranged above in a planar view, Fig. 3(b) is a sectional view taken along the line A-A of Fig. 3(a), and Fig. 3(c) is a bottom view showing the circuit member disposed on the bottom surface of the second base arranged below in a planar view.

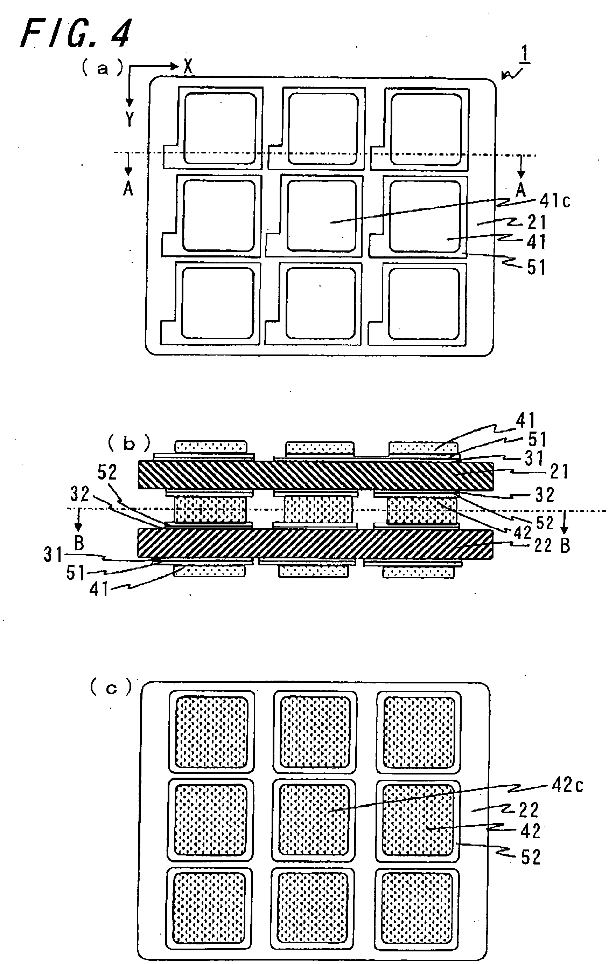

Fig. 4 is a diagram for explaining yet another embodiment of the laminated heat dissipating base body of the invention, wherein Fig. 4(a) is a plan view showing the circuit member disposed on the top surface of the first base arranged above in a planar view, Fig. 4(b) is a sectional view taken along the line A-A of Fig. 4(a), and Fig. 4(c) is a sectional view taken along the line B-B of Fig. 4(b).

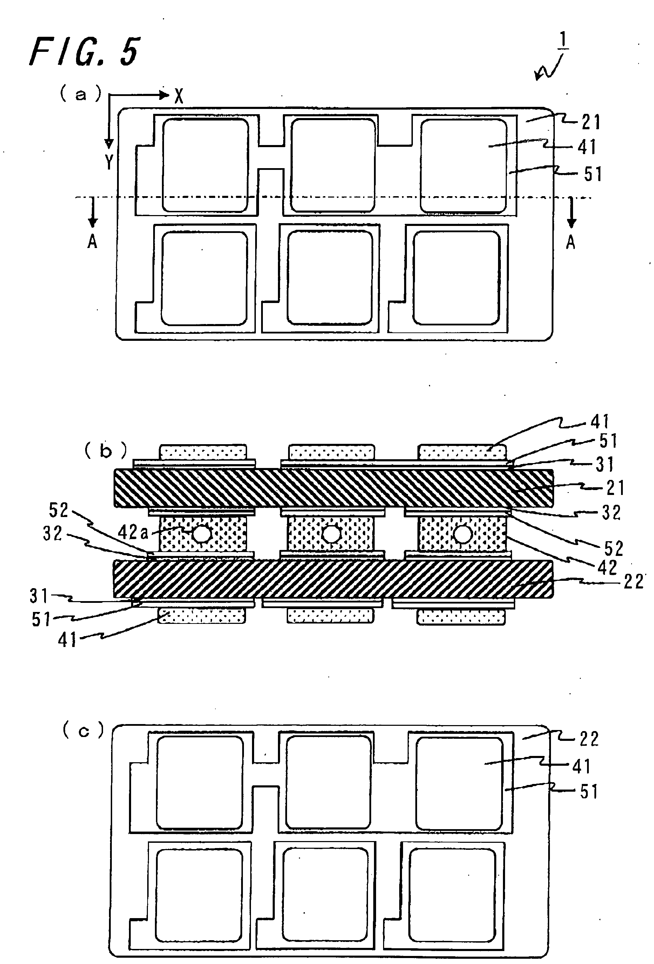

Fig. 5 is a diagram for explaining further embodiment of the laminated heat dissipating base body of the invention, wherein Fig. 5(a) is a plan view showing the circuit member disposed on the top surface of the first base arranged above in a planar view, Fig. 5(b) is a front view of the construction shown in Fig. 5(a), and Fig. 5(c) is a bottom view showing the circuit member disposed on the bottom surface of the second base arranged below in a planar view.

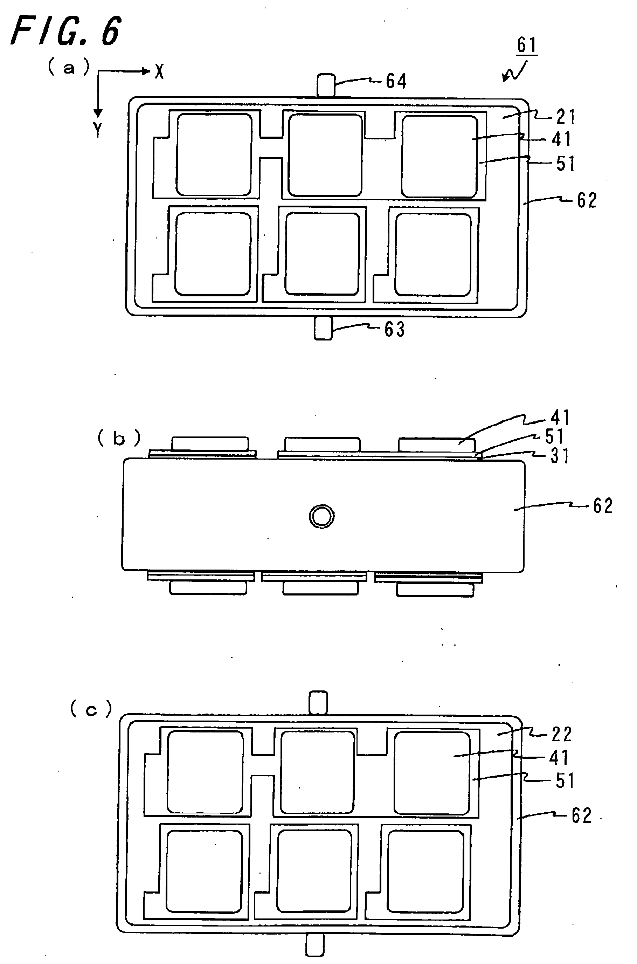

Fig. 6 is a diagram for explaining one embodiment of a heat dissipating unit of the invention, wherein Fig. 6(a) is a plan view showing the circuit member disposed on the top surface of the first base arranged above in a planar view, Fig. 6(b) is a front view of the construction shown in Fig. 6(a), and Fig. 6(c) is a bottom view showing the circuit member disposed on the bottom surface of the second base arranged below in a planar view.

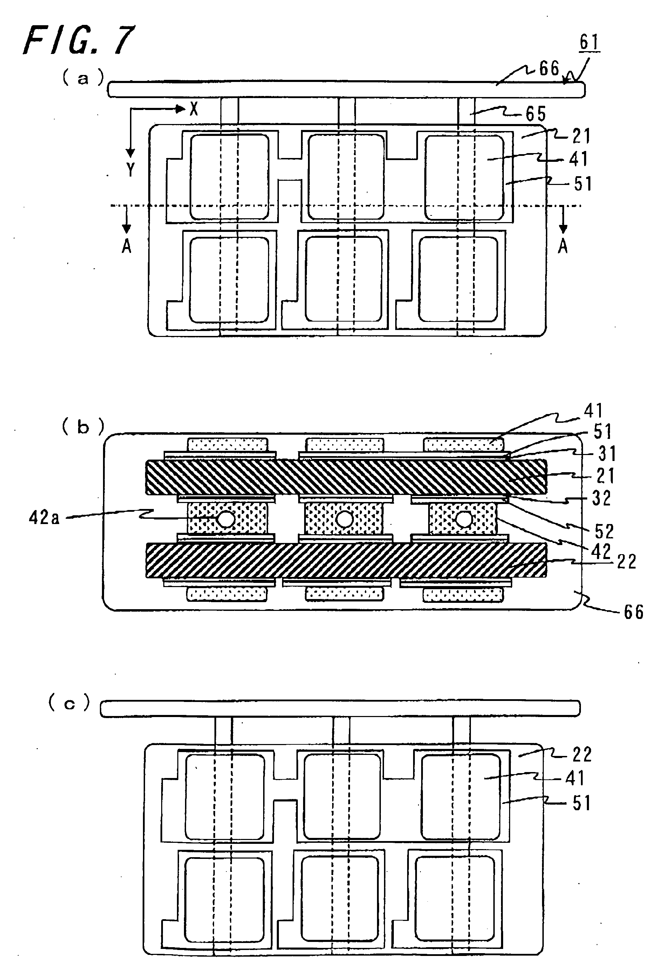

Fig. 7 is a diagram for explaining another embodiment of the heat dissipating unit of the invention, wherein Fig. 7(a) is a plan view showing the circuit member disposed on the top surface of the first base arranged above in a planar view, Fig. 7(b) is a front view of the construction shown in Fig. 7(a), and Fig. 7(c) is a bottom view showing the circuit member disposed on the bottom surface of the second base arranged below in a planar view.

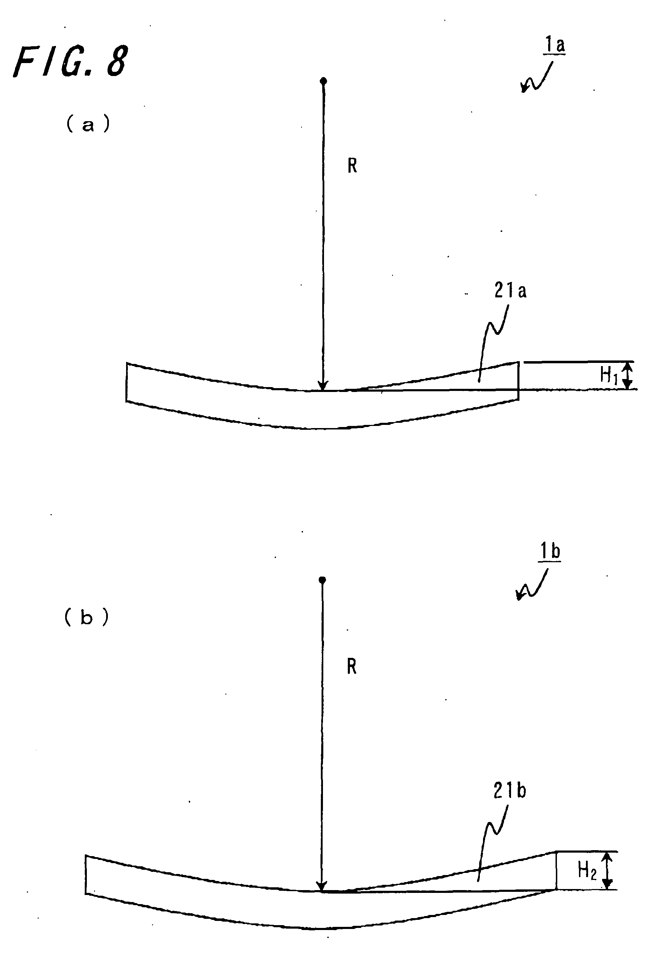

Fig. 8(a) is a diagram schematically showing warpage of the first base constituting a laminated heat dissipating base body 1a of the embodiment in which the circuit members are arranged in an array of one row and a plurality of columns, or arranged in an array of a plurality of rows and one column on the top surface of the first base, and Fig. 8(b) is a diagram schematically showing warpage of the first base constituting the laminated heat dissipating base body of the embodiment in which the circuit members are arranged in an array of one row and a plurality of columns, or arranged in an array of a plurality of rows and one column on the top surface of the first base.
Fig. 9 is a sectional view showing an example of a laminated heat dissipating base body of conventional design.

### Reference Sign List

- 1: Laminated heat dissipating base body
- 21: First base
- 22: Second base
- 31: First active metal layer
- 32: Second active metal layer
- 41: Circuit member
- 42: Heat dissipating member
- 51: First bonding layer
- 52: Second bonding layer
- 61: Heat dissipating unit
- 62: Frame body
- 63: Inlet
- 64: Outlet
- 65: Cooling pipe
- 66: Cooling means

### Best Mode for Carrying out the Invention

Now referring to the drawings, best modes for carrying out the invention are described below.

As shown in Fig. 1, a laminated heat dissipating base body 1 of the embodiment comprises: a first base 21 and a second base 22 having insulation properties arranged one above the other to face each other; a heat dissipating member 42 sandwiched between the first base 21 and the second base 22; and circuit members 41 disposed on a top surface of the first base 21 arranged above the second base 22 and a bottom surface of the second base 22 arranged below the first base 21, respectively. A bonding member is interposed in at least either between the first base 21 (the second base 22 as well) and the heat dissipating member 42 or between the first base 21 (the second base 22 as well) and the circuit member 41 (in the construction shown in Fig. 1, the bonding member is interposed both between the first base 21 (the second base 22 as well) and the heat dissipating member 42 and between the first base 21 (the second base 22 as well) and the circuit member 41). Moreover, the first base 21 and the second base 22 are each made of ceramics containing silicon nitride as a major constituent. The heat dissipating member 42 is made of a material containing copper as a major constituent. The circuit member 41 is made of a material containing copper as a major constituent. The bonding member includes a first active metal layer 31 (a second active metal layer 32 as well), and a first bonding layer 51 (a second bonding layer 52 as well) made of a metal containing copper as a major constituent.

It is preferable that the first and second bonding layers 51 and 52 are each, as will hereinafter be described, made of a metal containing copper as a major constituent (Cu content is 70% by mass or above). Alternatively, aluminum, an aluminum alloy, an alloy composed predominantly of Mo or W such as a Cu-Mo alloy (Cu content is 15% by mass or above) or a Cu-W alloy (Cu content is 11% by mass or above), and brass (Cu content is 57% by mass or above) may be adopted for use. Similarly, the circuit member 41, while preferably being made of a material composed predominantly of copper as will hereinafter be described, may be made of aluminum or an aluminum alloy, and also the heat dissipating member 42, while preferably being made of a material composed predominantly of copper as will hereinafter be described, may be made of any of a metal such as Cu-Mo, Cu-W, aluminum, and an aluminum alloy, Al-SiC (metal-ceramic impregnated material), sintered Cu-diamond, and the like.

Such a laminated heat dissipating base body 1 can be applied in the speeding up of dissipation of heat from electronic components including a semiconductor element such as an insulated gate bipolar transistor (IGBT) and a metal oxide semiconductor field-effect transistor (MOSFET), a dye-sublimation thermal printer head element, and a thermal ink-jet printer head element.

The first and second bases 21 and 22 constituting the laminated heat dissipating base body 1 are each made of sintered silicon nitride or a silicon nitride single crystal. Silicon nitride exhibits a thermal conductivity as high as 40 W/(m·K) or above and is excellent in heat dissipation characteristics. Each of the first and second bases 21 and 22 ranges from 30 to 80 mm in length in an X direction indicated in Fig. 1, and ranges from 10 to 80 mm in length in a Y direction indicated in Fig. 1. Moreover, it is advisable that the thickness of each base ranges from 0.13 to 0.4 mm from the viewpoint of low thermal resistance and high durability.

Given that the mass of the base is represented as 100% by mass, then the silicon nitride content in each of the first and second bases 21 and 22 is at least 80% by mass or above. In addition, as additive components, erbium oxide, magnesium oxide, silicon oxide, molybdenum oxide, aluminum oxide, and the like may be contained therein.

To achieve improvements in heat dissipation characteristics in particular, it is desirable to use aluminum oxide alone as an additive component, and the content thereof is preferably set at or below 0.3% by mass.

The first and second bases 21 and 22 have the following mechanical characteristics: a three-point bending strength of 700 MPa or above; Young's modulus of 300 GPa or above; a Vickers hardness (Hv) of 13 GPa or above; and also a fracture toughness (K_{1C}) of preferably 5 MPam^{1/2} or above. This allows the resulting laminated heat dissipating base body 1 to give a long-term service. Moreover, a higher degree of reliability, and more particularly improved creep resistance and heat cycle durability can be ensured so long as the mechanical characteristics take on the values falling in the aforementioned ranges.

Where the three-point bending strength is concerned, at first, the first active metal layer 31, the second active metal layer 32, the first bonding layer 51, the second bonding layer 52, the circuit member 41, and the heat dissipating member 42 are removed from the laminated heat dissipating base body 1 by means of etching. After that, measurement is conducted in conformity with JIS R 1601-1995. However, in a case where the thickness of the first base 21 (the second base 22 as well) is so small that it is impossible to set the thickness of a test piece cut from the first base 21 (the second base 22 as well) at 3 mm, the thickness of the first base 21 (the second base 22 as well) in itself is deemed as the thickness of the test piece for evaluation. The result of measurement shall fulfill the aforementioned three-point bending strength value.

Further, where the Young's modulus is concerned, at first, the first active metal layer 31, the second active metal layer 32, the first bonding layer 51, the second bonding layer 52, the circuit member 41, and the heat dissipating member 42 are removed from the laminated heat dissipating base body 1 by means of etching. After that, measurement is conducted in accordance with the Indentation Fracture method (IF method) defined by JIS R 1602-1995. However, in a case where the thickness of the first base 21 (the second base 22 as well) is so small that it is impossible to set the thickness of a test piece cut from the first base 21 (the second base 22 as well) at 4 mem, the thickness of the first base 21 (the second base 22 as well) in itself is deemed as the thickness of the test piece for evaluation. The result of measurement shall fulfill the aforementioned Young's modulus value.

The Vickers hardness (Hv) and the fracture toughness (K_{1C}) are measured in conformity with JIS R 1610-2003 and JIS R 1607-1995, respectively.

In terms of electrical characteristics, it is preferable that the volume resistivity of the base is greater than or equal to 10¹⁴ Ω·cm at room temperatures, and is greater than or equal to 10¹² Ω·cm at 300°C. This makes it possible to prevent leakage of electric current from the circuit member side to the heat dissipating member side during the operation of the laminated heat dissipating base body 1, and thereby lessen the degree of power loss. It is also possible to decrease the possibility that the electronic device fails to work properly.

The first active metal layer 31 and the second active metal layer 32 formed on the respective main surfaces of the first base 21 (the second base 22 as well) are each made for example of an active metal such as titanium (Ti), zirconium (Zr), and hafnium (Hf), or may occasionally be made of a tin (Sn)-containing Ag-Cu alloy or Au-Cu alloy. For example, with respect to the line A-A, each and every first active metal layer 31 ranges in length in the X direction from 12.4 to 24.4 mm, ranges in length in the Y direction from 16.4 to 20.4 mm, and ranges in thickness from 10 to 20 µm. On the other hand, for example, with respect to the line A-A, each and every second active metal layer 32 ranges in length in the X direction from 12.4 to 22.4 mm, ranges in length in the Y direction from 16.4 to 24.4 mm, and ranges in thickness from 10 to 20 µm.

The first bonding layer 51 and the second bonding layer 52 interposed between the first active metal layer 31 and the circuit member 41 and between the second active metal layer 32 and the heat dissipating member 42, respectively, are each composed predominantly of copper. With the action of diffusion of copper or a copper alloy which is a major constituent of the first and second bonding layers 51 and 52, the circuit member 41 and the heat dissipating member 42 can be bonded firmly to their respective main surfaces at a temperature as low as 300 to 500°C. Moreover, with the readily deformable nature of the first and second bonding layers 51 and 52, the bonding can be achieved under a small load. Further, a thermal stress induced during cooling can be relieved by the deformation of the first and second bonding layers 51 and 52. Accordingly, occurrence of warpage can be prevented even in the case of bonding the circuit member 41 and the heat dissipating member 42 having a larger thickness. In addition, since the resulting laminated heat dissipating base body 1 is excellent in heat dissipation characteristics, there is no need to provide a heat sink.

Further, it is preferable that the first and second bonding layers 51 and 52 are each composed predominantly of copper. Optimally each of the first and second bonding layers 51 and 52 should contain copper as a major constituent in an amount of greater than or equal to 99.96% by mass. In forming the first and second bonding layers 51 and 52, it is desirable to use a copper material, such as oxygen-free copper, tough pitch copper, and phosphorus deoxidized copper, capable of achieving firm bonding between the first active metal layer 31 and the circuit member 41 and between the second active metal layer 32 and the heat dissipating member 42. It is particularly desirable to use, out of oxygen-free copper materials, any of linear crystal oxygen-free copper, single crystal high-purity oxygen-free copper, and vacuum melted copper that have a copper content of greater than or equal to 99. 995% by mass. This is because, the higher is the copper content, the lower is the electrical resistance and the higher is the heat conductivity. Accordingly, excellent circuit characteristics (special property of being able to prevent heat generation in electronic components and thus reduce power loss) and excellent heat dissipation characteristics can be attained. Moreover, the higher is the copper content, the lower is the yield stress and the more likely it is that there arises plastic deformation at high temperatures. Accordingly, the strength of bonding between the first bonding layer 51 and the circuit member 41 and between the second bonding layer 52 and the heat dissipating member 42 can be increased with consequent enhancement in reliability,

It is especially preferable that the bonding member is interposed both between the first base 21 (the second base 22 as well) and the heat dissipating member 42 and between the first base 21 (the second base 22 as well) and the circuit member 41.

Note that an intermediate layer may be inserted between the first active metal layer 31 and the first bonding layer 51 or between the second active metal layer 32 and the second bonding layer 52. In order to alleviate distortion resulting from the differences in thermal expansion coefficient among the first and second bases 21 and 22, the first and second active metal layers 31 and 32, and the first and second bonding layers 51 and 52, the intermediate layer should preferably be made of a material which is readily deformable elastically or plastically. For example, it is preferable that the intermediate layer is made of Al, Ni, an alloy containing such a metal, or such a metal-based foam metal or metallic wire bundle. Moreover, in order to relax a thermal stress induced during cooling in the course of bonding operation, the intermediate layer should preferably contain a component which is smaller than copper but larger than silicon nitride in thermal expansion coefficient, for example, at least one of W, Mo, Ti, Cu-Mo, Cu-W, and WC-Co.

In each and every circuit member 41, the length thereof in the X direction is so selected as to fall in a range of from 10 to 17 mm, the length thereof in the Y direction is so selected as to fall in a range of from 10 to 20 mm, and the thickness thereof is so selected as to fall in a range of from 0.5 to 5 mm in accordance with the magnitude of electric current passing through the circuit and the amount of heat produced in an electronic component such as a semiconductor element mounted on the circuit member 41. Moreover, the heat dissipating member 42 has the function of dissipating heat liberated by the electronic component in a heat-producing state. Each and every heat dissipating member 42 ranges in length in the X direction from 10 to 17 mm, ranges in length in the Y direction from 10 to 20 mm, and ranges in thickness from 0.5 to 5 mm.

It is preferable that the circuit member 41 and the heat dissipating member 42 are each composed predominantly of copper or a copper alloy. In this case, the copper or copper alloy should preferably constitute 90% or above of each of the circuit member 41 and the heat dissipating member 42 by mass. It is desirable to use a copper material such as oxygen-free copper, tough pitch copper, and phosphorus deoxidized copper. Out of oxygen-free copper materials, any of linear crystal oxygen-free copper, single crystal high-purity oxygen-free copper, and vacuum melted copper that have a copper content of greater than or equal to 99. 995% by mass is particularly desirable for use.

Moreover, it is preferable that the circuit members 41 are arranged in the form of a matrix with a plurality of rows and a plurality of columns. By arranging the circuit members 41 in matrix form, it is possible to design the first base 21 (the second base 22 as well) in the shape of a square or a nearly-square rectangle, and thereby suppress warpage occurring in the laminated heat dissipating base body 1.

By the same token, it is preferable that the heat dissipating members 42 are also arranged in the form of a matrix with a plurality of rows and a plurality of columns.

Next, various embodiments of the laminated heat dissipating base body pursuant to the invention will be described with reference to Figs. 2 to 5. In these figures, such constituent components as are common to those in Fig. 1 are denoted by the same reference signs.

In the laminated heat dissipating base body 1 shown in Fig. 2, the first bonding layer 51 consists of irregular parts that are continuous with each other so as to extend over the circuit members 41. In this construction, since the first bonding layer 51 serves as a wiring line for establishing connection between the circuit members 41, it is possible to eliminate the need to install wire interconnection. As another advantage, where the first bonding layer 51 has a large thickness, great current can be passed through the electronic component such as a semiconductor element.

In the laminated heat dissipating base body 1 shown in Fig. 3, just like the laminated heat dissipating base body shown in Fig. 2, the first bonding layer 51 consists of irregular parts that are continuous with each other so as to extend over the circuit members 41. The difference between the laminated heat dissipating base body 1 shown in Fig. 3 and that shown in Fig. 2 is that the thickness of the first bonding layer 51 varies from part to part, and more specifically, as compared with a region of the first bonding layer on which is placed the circuit member 41, which is termed "the circuit member placement region E", a region thereof located between the adjacent circuit members 41, which is termed "the inter-circuit member region F", is made smaller in thickness.

Now, warpage occurring in the laminated heat dissipating base body will be described with reference to Fig. 8. Fig. 8(a) is a diagram schematically showing warpage occurring in a first base 21a constituting a laminated heat dissipating base body 1a of the present embodiment in which the circuit members are arranged in an array of one row and a plurality of columns, or arranged in an array of a plurality of rows and one column on the top surface of the first base 21a. Fig. 8(b) is a diagram schematically showing warpage occurring in a first base 21b constituting a laminated heat dissipating base body 1b of the present embodiment in which the circuit members are arranged in an array of one row and a plurality of columns, or arranged in an array of a plurality of rows and one column on the top surface of the first base 21b. As compared with the laminated heat dissipating base body 1b in which the circuit members 41 are arranged in an array of one row and a plurality of columns, or arranged in an array of a plurality of rows and one column on the top surface of the first base, in the laminated heat dissipating base body 1a in which the circuit members 41 are arranged in the form of a matrix with a plurality of rows and a plurality of columns, the first base 21a can be made shorter in longitudinal length. Therefore, where the laminated heat dissipating base bodies 1a and 1b are equal in radius of curvature (R) of warpage, a warpage (H₁) occurring in the first base 21a of the laminated heat dissipating base body 1a of the present embodiment can be smaller than a warpage (H₂) occurring in the first base 21b of the laminated heat dissipating base body 1b.

It is also preferable that the thickness of the heat dissipating member 42 is 1 to 10 times that of the circuit member 41. By setting the thickness of the heat dissipating member 42 within the limits, several advantages can be gained: the laminated heat dissipating base body 1 can be made compact, wherefore the heat liberated by the electronic component can be diffused thoroughly; a member having a forced cooling capability can be incorporated into the heat dissipating member 42, wherefore efficient heat dissipation can be achieved; and the heat dissipating member 42 can be made sufficiently thick with consequent increase in the rigidity of the laminated heat dissipating base body 1, and thus, even if the laminated heat dissipating base body 1 is subjected to thermal hysteresis, by virtue of deformation constraint effect, warpage can be suppressed with consequent increase in reliability.

Moreover, the heat diffusivity of the heat dissipating member 42 and the reliability of the laminated heat dissipating base body 1 vary depending on the position of an end face of the heat dissipating member 42 in a planar view in a see-through manner from above (as viewed in the thicknesswise direction). It is preferable that the end face of the heat dissipating member 42 in a planar view in a see-through manner (as viewed in the thicknesswise direction) is located outwardly from an end face of the circuit member 41. By doing so, the heat diffused in the circuit member 41 can be further diffused in the heat dissipating member 42. This helps enhance the heat dissipation characteristics even further. For example, it is advisable that the end face of the heat dissipating member 42 in a planar view in a see-through manner from above (as viewed in the thicknesswise direction) is spaced 0.1 to 2 mm outwardly from the end face of the circuit member 41.

Moreover, it is preferable that the end face of the heat dissipating member 42 in a planar view in a see-through manner from above (as viewed in the thicknesswise direction) is located inwardly from an end face of the first base 21 or the second base 22. By doing so, the most part of the heat dissipating member 42 is subjected to constraint, and therefore, even in the presence of thermal hysteresis, the stress exerted at the interface between the second bonding layer 52 and the heat dissipating member 42 can be reduced with consequent increase in reliability. For example, the end face of the heat dissipating member 42 in a planar view in a see-through manner from above (as viewed in the thicknesswise direction) is spaced 0.1 to 5 mm inwardly from the end face of the first base 21 or the second base 22.

Especially, it is preferable that each of the circuit member 41 and the heat dissipating member 42 ranges in Vickers hardness (Hv) from 0.5 to 1.2 GPa.

Note that the volume of each of the circuit member 41 and the heat dissipating member 42 can be measured by means of a three-dimensional shape measuring instrument, or can also be measured by means of a metallographic microscope, an image measuring instrument, or otherwise at a magnification of 2 to 10 times. It is advisable that the Vickers hardness (Hv) of each of the circuit member 41 and the heat dissipating member 42 is measured in conformity with JIS Z 2244-2003. A test load adopted for measurement is dependent on the thickness of each of the circuit member 41 and the heat dissipating member 42. For example, the test load is set at 196 mN (millinewton).

In the laminated heat dissipating base body as shown in Fig. 4, the circuit members 41 and the heat dissipating members 42, which are bonded to their respective main surfaces of the first base 21 (the second base 22 as well), are arranged in the form of a matrix with three rows and three columns. This laminated heat dissipating base body 1 is one of examples in which the circuit members 41 and the heat dissipating members 42 to be bonded to their respective base main surfaces are arranged in the form of a matrix with an odd number of plural rows and an odd number of plural columns. In this construction, a heat dissipating member 41c and a circuit member 42c lie on a point of intersection of two diagonal lines each connecting the opposite corners of the square-shaped first base 21 (the square-shaped second base 22 as well), wherefore the deformation of the laminated heat dissipating base body 1 occurring during the step of bonding the heat dissipating member 41c and the circuit member 42c is constrained. This makes it possible to suppress warpage occurring in the laminated heat dissipating base body 1 successfully.

In the laminated heat dissipating base body 1 as shown in Fig. 5, the heat dissipating member 42 is formed with a hollow 42a. For example, the hollow 42a is a columnar space. As compared with the heat dissipating member devoid of the hollow 42a, the heat dissipating member 42 having the hollow 42a has a larger surface area as a whole, wherefore the heat dissipation characteristics can be enhanced even further. Moreover, a member having a forced cooling capability can be set in the hollow. This makes it possible to dissipate the heat liberated by the electronic component more efficiently.

It is preferable that the proportion of the hollow 42a to the entire heat dissipating member 42 falls in a range of 20% by volume or more and 80% by volume or less. By doing so, the risk of buckling distortion and buckling fracture can be reduced in the bonding step, and also the surface area of the hollow 42a can be increased. This leads to further enhancement in the heat dissipation characteristics.

Moreover, the hardness of the first bonding layer S1 affects the strength of bonding between it and the circuit member 41, and similarly the hardness of the second bonding layer 52 affects the strength of bonding between it and the heat dissipating member 42. In the laminated heat dissipating base body 1 of the invention, the Vickers hardness (Hv) of each of the bonding layers 51 and 52 is preferably set at or below 0.5 GPa. By setting the Vickers hardness (Hv) in that way, the bonding layers 51 and 52 are readily deformable with consequent increase in the strength of bonding between the bonding layer and the circuit member 41 as well as the heat dissipating member 42. It is particularly desirable to set the Vickers hardness (Hv) in a range of from 0.2 to 0.5 GPa.

Further, it is advisable that the Vickers hardness (Hv) of each of the first and second bonding layers 51 and 52 is measured in conformity with JIS Z 2244-2003. A test load adopted for measurement is dependent on the thickness of each of the first and second bonding layers 51 and 52. For example, the test load is set at 98 mN or 196 mN.

In Fig. 6, there is shown a heat dissipating unit 61 having a frame body 62 disposed in contact with the top surface of the first base 21, the bottom surface of the second base 22, the side surfaces of the first base 21, and the side surfaces of the second base 22, for surrounding the laminated heat dissipating base body 1. The frame body 62 is made of one or more of materials including copper, a copper alloy, aluminum, an aluminum alloy, and resin. In the heat dissipating unit 61, a cooling medium such as water, coolant water, oil, liquid nitrogen, or liquid argon is introduced into the frame body 62 through a pipe-shaped inlet 63 inserted into the frame body 62. The inlet 63 is made of the aforementioned metal material or resin. By allowing the cooling medium to fill the space sandwiched between the bases 21 and 22, it is possible to effect cooling. The cooling medium that was used for cooling is discharged through a pipe-shaped outlet 64 disposed in the frame body 62. The outlet 64 made of the aforementioned metal material or resin. In the heat dissipating unit 61 thereby constructed, the laminated heat dissipating base body 1 can be cooled down efficiently and inexpensively without the necessity of providing a large-sized cooling device.

While, in the heat dissipating unit 61 shown in Fig. 6, the frame body 62 is disposed in contact with the top surface of the first base 21, the bottom surface of the second base 22, the side surfaces of the first base 21, and the side surfaces of the second base 22, the frame body 62 may be so di.sposed as to make contact with at least one of the top surface of the first base 21 and the bottom surface of the second base 22.

In the heat dissipating unit 61 shown in Fig. 7, a cooling pipe 65 such as a heat pipe is inserted in the hollow 42a. For example, the cooling pipe 65 is made of any of copper, a copper alloy, aluminum, and an aluminum alloy. Cooling means 66 such as a radiator is connected to the cooling pipe 65.

In the heat dissipating unit 61 thereby constructed, the laminated heat dissipating base body can be cooled down efficiently and inexpensively without the necessity of providing a large-sized cooling device.

By mounting electronic components on the circuit members 41 constituting the laminated heat dissipating base body 1 or the heat dissipating unit 61 which exhibits high heat dissipation capability as has already been described, the electronic device of the invention is free from accumulation of heat in the electronic components during operation and hence succeeds in offering high heat dissipation capability.

Next, how the laminated heat dissipating base body of the invention is to be manufactured will be described below.

The laminated heat dissipating base body 1 of the invention is constructed as follows. At first, a paste of a Ag-Cu alloy or Au-Cu alloy, which contains an active metal such as titanium (Ti), zirconium (Zr), hafnium (Hf), etc. and may occasionally contain tin (Sn), is applied onto both of the main surfaces of the first base 21 (the second base 22 as well) made of sintered silicon nitride that ranges in length from 30 to 80 mm, ranges in width from 10 to 80 mm, and ranges in thickness from 0.13 to 0.4 mm by means of screen printing, roll coater technique, brush coating, or otherwise. Then, on the paste is laminated a copper foil composed predominantly of copper and having a thickness of 0.1 to 0.6 µm, and the laminated body is caused to melt under application of heat at a temperature of 800 to 900°C. In this way, the first and second active metal layers 31 and 32 and the first and second bonding layers 51 and 52 composed predominantly of copper are formed.

Subsequently that surface of the first bonding layer 51 which makes contact with the circuit member 41 and that surface of the second bonding layer 52 which makes contact with the heat dissipating member 42 are each polished. After that, in an atmosphere selected from among hydrogen, nitrogen, neon, argon, and the like inert gases, the workpiece is heated to a temperature ranging from 300 to 500°C. Then, under a pressure of greater than or equal to 30 MPa, the circuit members 41 and the heat dissipating members 42, whose surfaces to be bonded to their respective first and second bonding layers 51 and 52 are made flat, are arranged in the form of, for example, a matrix with three rows and two columns or a matrix with three rows and three columns. Following the completion of their bonding, the laminated heat dissipating base body 1 is obtained. The laminated heat dissipating base body 1 is then cooled down to a temperature at which neither copper nor copper alloy will be oxidized (50°C) under application of pressure. Upon this temperature being reached, the pressurization is brought to an end and the laminated heat dissipating base body 1 is taken out. Where the formation of the circuit in the circuit member 41 is concerned, specifically, it is possible to use a copper plate having a circuit formed therein in advance by patterning using press working or etching technique. It is also possible to form a circuit by patterning using etching, laser processing, or the like technique following the completion of bonding of the circuit member.

Moreover, in order to design the first bonding layer 51 such that it extends over a plurality of the circuit members 41 and that its thickness varies from part to part; that is, the inter-circuit member region F is smaller in thickness than the circuit member placement region E, the first bonding layer 51 formed in accordance with the aforestated method is subjected to etching, laser processing, or the like operation, with the areas thereof other than the inter-circuit member region F kept masked, so that that part of the first bonding layer 51 which corresponds to the inter-circuit member region F can be processed into a thin region. After that, the masking material is removed, whereupon the laminated heat dissipating base body 1 can be obtained.

As will be understood from the foregoing, in contrast to the case of performing bonding by using one of the copper direct bonding method, the metallization method with metal having a high melting point, the active brazing method, and so forth, it is possible to lessen the degree of bonding-induced warpage in the circuit member 41 and in the heat dissipating member 42, and thereby increase the thicknesses of, respectively, the circuit member 41 and the heat dissipating member 42. The laminated heat dissipating base body 1 in which the circuit member 41 and the heat dissipating member 42 have a large thickness is able to offer enhanced heat dissipation characteristics and may occasionally be in no need of attachment of a heat sink.

Moreover, since the electronic component such as a semiconductor element is connected to the circuit member of the laminated heat dissipating base body 1, even during the use of the electronic device such as a semiconductor apparatus, it is possible to effectively prevent accumulation of heat in the electronic component.

Hence it follows that the laminated heat dissipating base body 1 of the invention is excellent in heat dissipation characteristics as heretofore described and is therefore applicable to a substrate for use in a dye-sublimation thermal printer head, a planar heat-generating heater support substrate, a heater support substrate for use in a thermal ink-jet printer head, and so forth.

## Claims

1. A laminated heat dissipating base body comprising:
first and second bases having insulation properties arranged one above the other to face each other;
a heat dissipating member sandwiched between the first base and the second base; and
circuit members disposed on a top surface of the first base arranged above the second base and a bottom surface of the second base arranged below the first base, respectively,
the laminated heat dissipating base body being so designed that a bonding member is interposed at least either between the first base and the heat dissipating member or between the second base and the circuit member, the bonding member including an active metal layer containing an active metal disposed on the first and/or second base side thereof, and a bonding layer containing a metal disposed at least either on the heat dissipating member side thereof or on the circuit member side thereof.

2. The laminated heat dissipating base body of claim 1, wherein the first base and the second base are each made of ceramics containing silicon nitride as a major constituent, and the heat dissipating member, the circuit member, and the bonding layer are each made of a material containing copper as a major constituent.

3. The laminated heat dissipating base body of claim 1 or 2, wherein the circuit members are arranged in a form of a matrix with a plurality of rows and a plurality of columns.

4. The laminated heat dissipating base body of claim 3, wherein the circuit members are arranged in a form of a matrix with an odd number of rows and an odd number of columns.

5. The laminated heat dissipating base body of any one of claims 1 to 4, wherein a thickness of the heat dissipating member is 1 to 10 times that of the circuit member.

6. The laminated heat dissipating base body of any one of claims 1 to 5, wherein an end face of the heat dissipating member in a planar view in a see-through manner is located outwardly from an end face of the circuit member.

7. The laminated heat dissipating base body of any one of claims 1 to 6, wherein an end face of the heat dissipating member in a planar view in a see-through manner is located inwardly from an end face of the first base or the second base .

8. The laminated heat dissipating base body of any one of claims 1 to 7, wherein the heat dissipating member is formed with a hollow.

9. The laminated heat dissipating base body of claim 8, wherein a proportion of the hollow to the entire heat dissipating member falls in a range of 20% by volume or more and 80% by volume or less.

10. A heat dissipating unit comprising the laminated heat dissipating base body of any one of claims 1 to 9; and a frame body which surrounds the laminated heat dissipating base body, the heat dissipating unit being so designed that a cooling medium is admitted into the frame body.

11. A heat dissipating unit comprising the laminated heat dissipating base body of claim 8 or 9; and a cooling pipe inserted in the hollow of the laminated heat dissipating base body.

12. An electronic device comprising the laminated heat dissipating base body of any one of claims 1 to 9; and an electronic component mounted on the circuit member of the laminated heat dissipating base body.

13. An electronic device comprising the heat dissipating unit of claim 10 or 11; and an electronic component mounted on the circuit member of the heat dissipating unit.
